# EUROPÄISCHE PATENTSCHRIFT

(11) **EP 0 316 821 B1**
(45) Veröffentlichungstag und Bekanntmachung des Hinweises auf die Patenterteilung: **09.02.1994**
(21) Anmeldenummer: 88118884.1
(22) Anmeldetag: 12.11.1988
(51) Int. Cl.: H04Q 1/10, H04Q 1/14, H05K 5/00

(54) **Gehäuse zur Aufnahme von elektrischen Baugruppen**
Housing for containing electrical assemblies
Boîtier pour contenir des constituants électriques

(30) Priorität: 17.11.1987 DE 3738896
(43) Veröffentlichungstag der Anmeldung: 24.05.1989
(73) Patentinhaber: Alcatel SEL Aktiengesellschaft, D-70435 Stuttgart (DE)
(72) Erfinder: Kriegisch, Peter, D-7250 Leonberg (DE); Pickel, Wolfgang, D-7000 Stuttgart 1 (DE)
(74) Vertreter: Pohl, Herbert, Dipl.-Ing.

(56) Entgegenhaltungen:
- EP-A- 0 078 405
- EP-A- 0 133 301
- DE-B- 1 076 765
- ELEKTRONIK vol. 59, no. 13, Juli 1977, WURZBURG (DE) Seite 48 "PRAKTISCHES GEHAUSE-SYSTEM"

## Beschreibung

Die Erfindung betrifft ein Gehäuse zur Aufnahme von elektrischen Baugruppen, insbesondere von Netzabschlußgeräten der Nachrichtentechnik, das die Baugruppen abdeckende Seitenwände aufweist und den Blick auf die vordere Stirnseite von Baugruppenträgern freigibt.

Derartige Gehäuse sollten modular erweiterbar sein, um z.B. den Abschluß eines Fernmeldenetzes bilden zu können, an das unterschiedlich große Nebenstellenanlagen angeschlossen werden. Es sind Gehäuse bekannt, die modular erweiterbar sind, indem sie mit einer unterschiedlichen Anzahl von Einschüben bestückt werden (telecom report 10 (1987) Special "Multiplex- und Leitungseinrichtungen", Seite 204). Das Gehäuse selbst hat aber unveränderliche Abmessungen, so daß es in einigen Fällen zu groß und in anderen Fällen nicht ausreichend groß sein kann. Es sind auch Gehäuse für elektrische Baugruppen bekannt, die als sog. Anreihsystem ausgebildet sind, bei denen also je nach Bedarf weitere Baugruppenträger hinzugefügt werden können (DE-U-7 613 268). Solche Gehäuse lassen sich aber gegen einen unbefugten Zugriff schlecht sichern, außerdem muß jedes einzelne Teilgehäuse demontiert werden, wenn zu den darin enthaltenen Baugruppen zugegriffen werden soll.

Der Erfindung liegt die Aufgabe zugrunde, ein leicht erweiterbares Gehäuse zu schaffen, das in einfacher Weise zu verschließen ist.

Diese Aufgabe wird bei einem Gehäuse der eingangs genannten Art erfindungsgemäß dadurch gelöst,
- daß es einen Baugruppenträger enthält, der durch Halterungen an einer Grundplatte befestigt ist,
- daß die Halterungen durch Aufschrauben weiterer Halterungen derart verlängerbar sind, daß jeweils ein weiterer Baugruppenträger angefügt werden kann, und
- daß durch eine Deckplatte, die eine der Seitenwände des Gehäuses bildet, alle anderen Seitenwände bei geschlossenem Gehäuse zusammengefügt werden.

Vorteilhafte Weiterbildungen der Erfindung sind den Unteransprüchen entnehmbar.

Die Vorteile der Erfindung liegen u.a. darin, daß nach Abnahme der Deckplatte lediglich zwei Teile, nämlich das Abdeckblech und die Kunststoffscheibe, abgezogen werden müssen, um auch von hinten bequemen Zugang zu den Einschüben zu erhalten. Andererseits kann eine Bedienungsperson, auch ohne daß sie zu einem Eingriff in die Baugruppen befugt ist, ohne weiteres die Anzeigen auf der Einschubvorderseite beobachten und damit z.B. Störungen erkennen. Für unterschiedlich große Gehäuse werden lediglich zwei unterschiedlich große Bauteile benötigt, so daß sich die Lagerhaltung sehr vereinfacht.

Ausführungsbeispiele der Erfindung werden im folgenden anhand der Zeichnungen erläutert. Es zeigen:
- Fig. 1: ein Gehäuse gemäß der Erfindung in einer auseinandergezogenen Perspektivdarstellung,
- Fig. 2: Teile des Gehäuses nach Fig. 1 in einer auseinandergezogenen Seitenansicht,
- Fig. 3: ein anderes Ausführungsbeispiel des Gehäuses gemäß der Erfindung in einer Perspektivansicht von vorn, und
- Fig. 4: das Gehäuse nach Fig. 3 in einer Perspektivansicht von hinten, bei abgenommenen Gehäuseteilen.

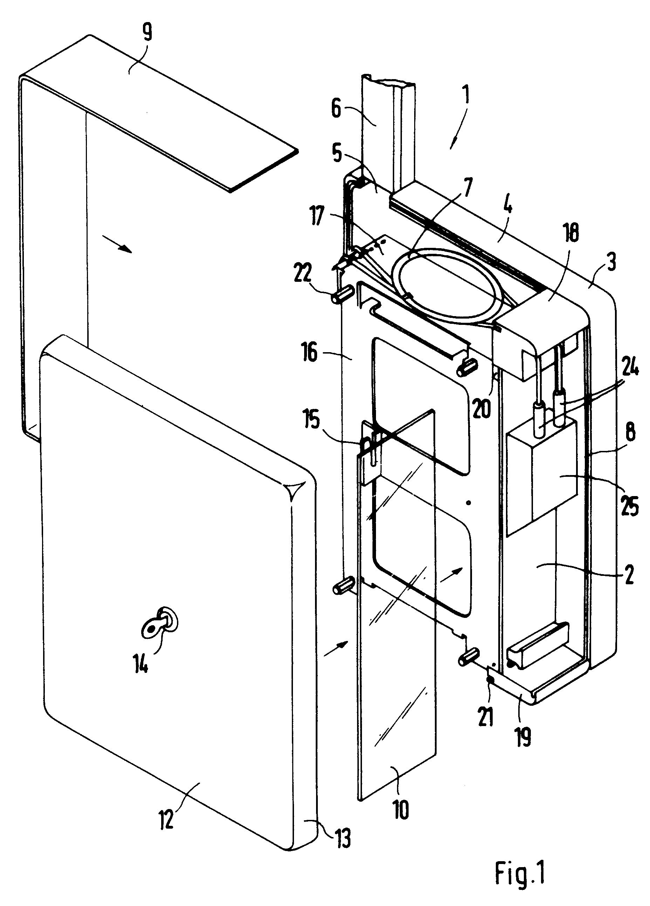

Ein aus Fig. 1 ersichtliches erfindungsgemäßes Gehäuse 1 ist für die Aufnahme nur eines Einschubes 2 vorgesehen. Dieser Einschub 2 stellt eine vollständige nachrichtentechnische Funktionseinheit dar, z.B. einen Basisanschluß- oder einen Primärmultiplex-Netzabschluß für ein ISDN-Fernmeldenetz. Der Einschub 2 enthält eine oder mehrere Leiterplatten, die die Baugruppen dieser Abschlußgeräte enthalten, die aber im einzelnen - da für die Erläuterung der Erfindung nicht notwendig - nicht dargestellt sind.

Das Gehäuse 1 schließt außer dem äußeren Gehäuse im engeren Sinne auch noch eine Anzahl weiterer Einrichtungen ein, die der Aufnahme und dem elektrischen und optischen Anschluß der Funktionseinheiten dienen. Der Ausdruck Gehäuse wird somit hier im weiteren Sinne - z.B. als Baugruppenrahmen oder Aufnahmeeinrichtung für Netzabschlußgeräte oder ähnliche Schaltungsbaugruppen - verwendet.

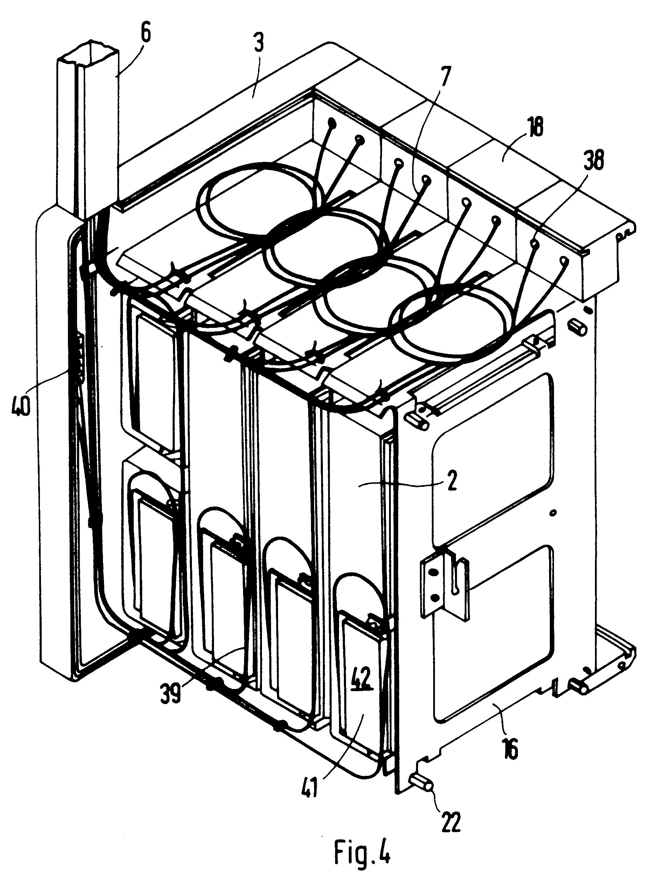

Eine Grundplatte 3 ist für die Wandbefestigung vorgesehen. An ihrem umlaufenden Rand 4 weist sie eine Aussparung 5 auf, an die im montierten Zustand ein Kabelschacht 6 angeschlossen ist, in dem an den Einschub 2 anzuschließende elektrische Leitungen (siehe Fig. 4) und Lichtwellenleiter-Kabel 7 geführt sind.

Die Grundplatte 3 bildet die - in dieser Zeichnungsdarstellung - rechte Seitenwand des Gehäuse 1. Ihr Rand 4 weist eine durchgehende Nut 8 auf. In diese Nut 8 wird einerseits ein U-förmiges Abdeckblech 9, das die obere, die hintere und die untere Seitenwand des Gehäuses 1 bildet, mit ihrem seitlichen Rand eingesteckt. Die vordere Seitenwand des Gehäuses 1 wird durch eine Plexiglas-Scheibe 10 gebildet, die ebenfalls mit ihrem Rand in die Nut 8 eingesteckt wird. Eine Deckplatte 12 bildet die linke Seitenwand des Gehäuses 1 und stellt außerdem dessen Verschluß dar.

Die Deckplatte 12 weist an ihrem Rand 13 ebenfalls eine durchgehende Nut auf, die beim Zusammenbau des Gehäuses 1 auf die linken Ränder des Abdeckblechs 9 und der Plexiglas-Scheibe 10 aufgeschoben wird. Die zum Zusammenbauen des Gehäuses erforderlichen Verschiebungen der Teile 9, 10 und 12 sind durch Pfeile angedeutet.

Die Deckplatte 12 bildet den Abschluß des Gehäuses 1. Sie weist ein Schloß 14 auf, das mit einem - in der Zeichnung nicht sichtbaren - schwenkbaren Schließriegel versehen ist, der in ein Schließblech 15 eingedreht werden kann. Damit kann das Gehäuse 1 verschlossen werden, so daß zur Wartung und Reparatur nicht befugte Personen keinen Zugriff zu den darin enthaltenen Schaltungsbaugruppen haben. Andererseits sind auf der Vorderseite des Einschubs 2 gegebenenfalls vorhandene Funktions- und Fehleranzeigen durch die Scheibe 10 jederzeit sichtbar. Das Schließblech 15 ist auf einer Montageplatte 16 befestigt, die den Raum für die Aufnahme des Einschubs 2 nach links begrenzt. Nach oben wird dieser Raum durch einen umgebogenen Schenkel 17 der Montageplatte begrenzt. Zwischen die Grundplatte 3 und die Montageplatte 16 sind ein oberes Distanzstück 18 und ein unteres Distanzstück 19 eingefügt, wobei ihre gegenseitige Lage durch Stifte 20 und 21 festgelegt ist.

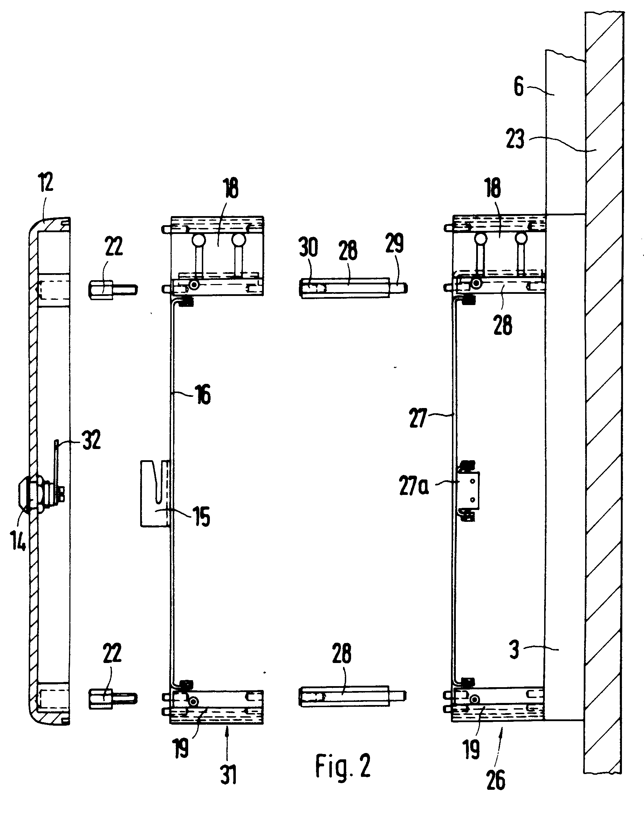

Die Montageplatte 16 ist durch vier verlängerbare Halterungen, von denen in Fig. 1 nur die jeweiligen Verschlußbolzen 22 ersichtlich sind, mit der Grundplatte 3 verbunden. Diese Halterungen werden anhand von Fig. 2 erläutert.

Das obere Distanzstück 18 ist mit zwei Aussparungen oder Bohrungen versehen, durch die die Lichtwellenleiter-Kabel 7 derart durchgeführt sind, daß das Einhalten des für sie vorgeschriebenen Mindest-Biegeradius gewährleistet ist. Die Lichtwellenleiter 7 sind über Stecker 24 an ein optisches Anschlußteil 25 angeschlossen, das z.B. opto-elektrische Wandler enthält.

Das Ausführungsbeispiel nach Fig. 1 stellt den Grundausbau des erfindungsgemäßen Gehäuses dar, das für die Aufnahme nur eines Einschubes 2 vorgesehen ist. Das Gehäuse läßt sich in sehr einfacher Weise als sogenanntes Anreihsystem erweitern. Es müssen dazu nur die erforderliche Anzahl weiterer Distanzstücke 18 und 19 und die entsprechenden Montageplatten 16 an der jeweils vorhergehenden Montageplatte 16 befestigt werden.

Aus Fig. 2, die den Zusammenbau eines erfindungsgemäßen Gehäuses für zwei Einschübe darstellt, ist der modulare Aufbau des Gehäuses deutlich zu erkennen. Die Grundplatte 3 ist an einer Wand 23 befestigt.

Ein erster Baugruppenträger 26, der an der Grundplatte 3 befestigt ist, wird im wesentlichen durch eine Montageplatte 27 sowie das obere Distanzstück 18 und das untere Distanzstück 19 gebildet. Die Montageplatte 27 entspricht weitgehend der Montageplatte 16, sie hat nur kein Schließblech. Um auch Einschübe mit halber Höhe - d.h. mit drei Höheneinheiten statt sechs Höheneinheiten - in dem Gehäuse aufnehmen zu können, ist eine Traverse 27a an die Montageplatte 27 geschraubt.

Der erste Baugruppenträger 26 ist durch vier Halterungen 28 auf der Grundplatte 3 befestigt. Die Halterungen 28 sind als Sechskantstäbe ausgebildet, die an ihrem einen Ende ein Außengewinde 29 und an ihrem anderen Ende ein Innengewinde 30 der gleichen Abmessung aufweisen. Damit kann auf jede Halterung 28 jeweils eine weitere Halterung 28 aufgeschraubt werden. Die ersten vier Halterungen 28 werden mit ihrem Außengewinde 29 in entsprechende Bohrungen in der Grundplatte 3 eingeschraubt. Danach wird der erste Baugruppenträger 26 auf die Halterungen 28 aufgeschoben. In die ersten Halterungen 28 werden vier weitere Halterungen 28 eingeschraubt und danach ein zweiter Baugruppenträger 31 aufgeschoben. Dieser Baugruppenträger 31 wird dann durch Aufschrauben von vier Verschlußbolzen 22 befestigt.

Nach Einstecken eines Abdeckblechs 9 und einer Plexiglas-Scheibe 10 (siehe Fig. 1) muß nur noch die Deckplatte 12 aufgeschoben werden, um das Gehäuse zu vervollständigen. Mit dem Schloß 14 kann der Schließriegel 32 in das Schließblech 15 hineingedreht und damit das Gehäuse verschlossen werden.

Für die verschiedenen Ausbaustufen des Gehäuses 1, d.h. für die Aufnahme unterschiedlicher Anzahlen von Einschüben, werden immer die gleichen Teile benötigt. Unterschiedlich sind lediglich das Abdeckblech 9 und die Plexiglas-Scheibe 10, die jeweils die erforderliche Breite aufweisen müssen. Damit vereinfacht sich die Lagerhaltung für die erfindungsgemäßen Gehäuse recht beträchtlich.

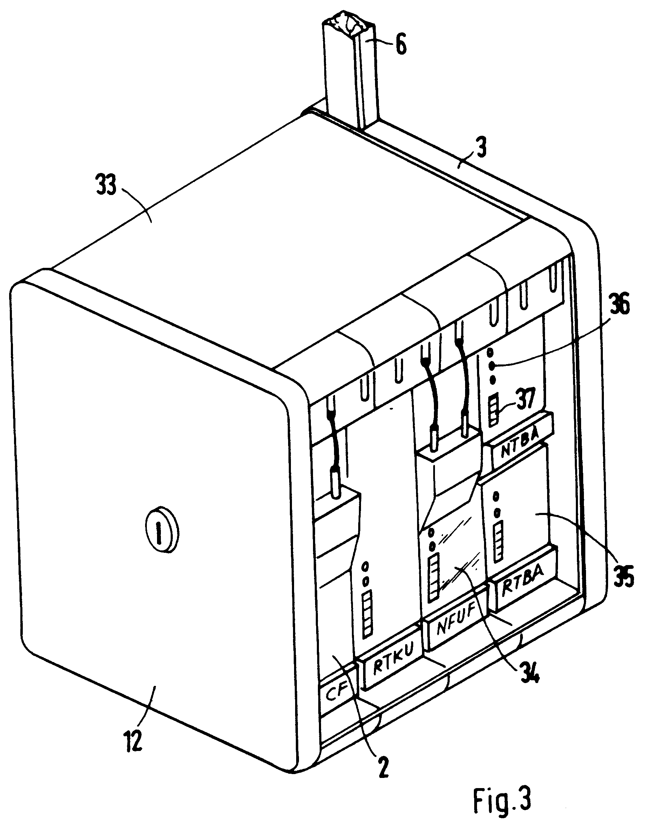

Das aus Fig. 3 ersichtliche Gehäuse, das für die Aufnahme von vier Einschüben vorgesehen ist, weist eine Grundplatte 3 und eine Deckplatte 12 auf, die zu den bereits beschriebenen identisch sind. Das gleiche gilt für die nicht im einzelnen dargestellten inneren Bauteile. Dagegen benötigt dieses Gehäuse ein breiteres Abdeckblech 33 und eine breitere Plexiglas-Scheibe 34.

Ein in Fig. 3 rechts in dem Gehäuse liegender Einschub 35, der z.B. Steuer- und Überwachungsschaltungen enthalten kann, ist auf seiner Frontplatte mit Leuchtdioden 36 und weiteren Anzeigeelementen 37 versehen, mit denen der Funktionszustand und ggf. Störungen der in dem Gehäuse enthaltenen Schaltungsbaugruppen angezeigt werden.

Die Ansicht von hinten (Fig. 4) zeigt den Verlauf der über den Kabelschacht 6 zugeführten Lichtwellenleiterkabel 7, die, wie bereits erwähnt, über Bohrungen 38 in den oberen Distanzstücken 18 den Einschüben zugeführt werden. Außerdem ist der Verlauf von Kupferkabeln 39 ersichtlich, mit denen z.B. eine 60-V-Versorgungsspannung von einem Verteiler 40 zu einer hinteren Anschlußplatte 41, die jeder Einschub 2 aufweist, zugeführt wird. Die Anschlußplatten 41 enthalten jeweils eine Steckerleiste, die durch eine Abdeckplatte 42 verdeckt ist.

Deutlich erkennbar ist in Fig. 4, das die in dem erfindungsgemäßen Gehäuse aufgenommenen Einschübe einschließlich der Anschlußplatten und der elektrischen und optischen Leitungen von allen Seiten, insbesondere auch von hinten sehr gut zugänglich sind, nachdem lediglich die Deckplatte 12 und das Abdeckblech 9 oder 33 abgenommen worden sind, wie in Fig. 4 dargestellt.

## Patentansprüche

1. Gehäuse zur Aufnahme von elektrischen Baugruppen, insbesondere von Netzabschlußgeräten der Nachrichtentechnik,
- das die Baugruppen abdeckende Seitenwände aufweist und den Blick auf eine Stirnseite von Baugruppenträgern freigibt,
**dadurch gekennzeichnet,**
- daß es einen Baugruppenträger (26) enthält, der durch Halterungen (28) an einer Grundplatte (3) befestigt ist,
- daß die Halterungen (28) durch Aufschrauben weiterer Halterungen (28) derart verlängerbar sind, daß jeweils ein weiterer Baugruppenträger (31) angefügt werden kann, und
- daß durch eine Deckplatte (12), die eine der Seitenwände des Gehäuses (1) bildet, alle anderen Seitenwände (9, 10) bei geschlossenem Gehäuse zusammengefügt sind.

2. Gehäuse nach Anspruch 1, dadurch gekennzeichnet, daß drei der anderen Seitenwände durch ein U-förmig gebogenes Abdeckblech (9) gebildet werden, das in Nuten (8) der Grundplatte (3) und der Deckplatte (12) eingesteckt ist.

3. Gehäuse nach Anspruch 1, dadurch gekennzeichnet, daß die vordere Seitenwand durch eine durchsichtige Kunststoffscheibe (10) gebildet ist.

4. Gehäuse nach Anspruch 1, dadurch gekennzeichnet, daß der Baugruppenträger (26) eine seitliche Montageplatte (16) aufweist, deren Stellung durch ein oberes und ein unteres Distanzstück (18, 19) festgelegt wird.

5. Gehäuse nach Anspruch 4, dadurch gekennzeichnet, daß die Montageplatte (16) des äußersten Baugruppenträgers (31) mit einem Schließblech (15) versehen ist, in das ein Schließriegel (32) eines in der Deckplatte (12) angeordneten Schlosses (14) eingreift.

6. Gehäuse nach Anspruch 1, dadurch gekennzeichnet, daß die Halterungen (28) als Profilstäbe ausgebildet sind, die an einem Ende ein Außengewinde (29) und an dem anderen Ende ein Innengewinde (30) der gleichen Abmessung aufweisen.

7. Gehäuse nach Anspruch 4, dadurch gekennzeichnet, daß in dem oberen Distanzstück (18) Kanäle (38) zum Durchführen von Lichtwellenleiter-Kabeln (7) vorhanden sind.

8. Gehäuse nach Anspruch 1, dadurch gekennzeichnet, daß die Grundplatte (3) für die Wandbefestigung ausgebildet ist und daß sie an ihrem Rand (4) eine Aussparung (5) aufweist, in die ein Kabelschacht (6) mündet.

## Claims

1. A housing for electrical modules, particularly for communications network termination units,
- which has sidewalls covering the modules and gives a view of one end of subracks,
**characterized in**
- that it contains a subrack (26) which is fixed to a base plate (3) by fasteners (28),
- that the fasteners (28) can be lengthened by screwing on further fasteners (28) such that respective further subracks (31) can be added, and
- that with the housing (1) locked, all other sidewalls (9, 10) are joined together by an end plate (12) which forms one of the sidewalls of the housing (1).

2. A housing as claimed in claim 1, characterized in that three of the other sidewalls are formed by a U-shaped cover plate (9) which is inserted into grooves (8) of the base plate (3) and the end plate (12).

3. A housing as claimed in claim 1, characterized in that the front sidewall is formed by a transparent plastic panel (10).

4. A housing as claimed in claim 1, characterized in that the subrack (26) comprises a lateral mounting plate (16) whose position is determined by an upper spacer (18) and a lower spacer (19).

5. A housing as claimed in claim 4, characterized in that the mounting plate (16) of the outermost subrack (31) is provided with a locking plate (15) which is engaged by a dead bolt (32) of a lock (14) mounted in the end plate (12).

6. A housing as claimed in claim 1, characterized in that the fasteners (28) are sectional bars which have an external thread (29) at one end and a corresponding internal thread (30) at the other end.

7. A housing as claimed in claim 4, characterized in that the upper spacer (18) contains channels (38) for passing fiber-optic cables (7) therethrough.

8. A housing as claimed in claim 1, characterized in that the base plate (3) is designed for wall mounting, and that its edge (4) has an opening (5) in which a cable conduit (6) ends.

## Revendications

1. Boîtier pour contenir des composants électriques, en particulier des terminaux de réseau de la technique des télécommunications,
- boîtier qui présente des parois latérales recouvrant les composants et permet la vue sur une face frontale des porte-composants,
boîtier caractérisé
- par le fait qu'il contient un porte-composants (26) qui est fixé, par des supports (28), à une plaque de base (3),
- par le fait que les supports (28) peuvent, par vissage d'autres supports (28), se prolonger de façon telle que l'on peut chaque fois ajouter un autre porte-composants (31) et
- par le fait qu'au moyen d'une plaque de recouvrement (12), qui forme l'une des parois latérales du boîtier (1), toutes les autres parois latérales (9, 10) sont assemblées, le boîtier étant fermé.

2. Boîtier selon la revendication 1, caractérisé par le fait que trois des autres parois latérales sont formées par une tôle de recouvrement (9) qui est cintrée en forme de U et qui s'enfiche dans des rainures (8) de la plaque de base (3) de la plaque de recouvrement (12).

3. Boîtier selon la revendication 1, caractérisé par le fait que la paroi latérale avant est formée par une vitre de plastique transparente (10).

4. Boîtier selon la revendication 1, caractérisé par le fait que le porte-composants (26) présente une plaque de montage latéral (16) dont la position est déterminée par une pièce d'écartement supérieure et une pièce d'écartement inférieure (18, 19).

5. Boîtier selon la revendication 4, caractérisé par le fait que la plaque de montage (16) du porte-composant le plus extérieur (31) est munie d'une gâche (15) dans laquelle pénètre un pêne (32) d'une serrure (14) disposée dans la plaque de recouvrement (12).

6. Boîtier selon la revendication 1, caractérisé par le fait que les supports (28) sont conçus sous forme de barreaux profilés qui, à une extrémité, présentent un filetage extérieur (29) et, à l'autre extrémité, un filetage intérieur (30) de même dimension.

7. Boîtier selon la revendication 4, caractérisé par le fait que dans la pièce d'écartement supérieure (18) se trouvent des canaux (38) pour le passage de câbles de guides d'ondes lumineuses (7).

8. Boîtier selon la revendication 1, caractérisé par le fait que la plaque de base (3) est conçue pour fixation à la paroi et par le fait qu'elle présente sur sa bordure (4) un évidement (5) dans lequel débouche un chemin de câble (6).
